# EUROPEAN PATENT APPLICATION

(11) **EP 4 739 042 A1**
(43) Date of publication of application: **06.05.2026**
(21) Application number: 24843363.3
(22) Date of filing: 01.07.2024
(51) Int. Cl.: H10H 20/855

(54) **DISPLAY DEVICE AND MANUFACTURING METHOD THEREFOR**

(30) Priority: 17.07.2023 KR 20230092740
(71) Applicant: LG Electronics Inc., Yeongdeungpo-gu Seoul 07336 (KR)
(72) Inventor: LEE, Sunju, Seoul 06772 (KR); LEE, Dohyung, Seoul 06772 (KR); PARK, Sangdae, Seoul 06772 (KR); YUH, Hwankuk, Seoul 06772 (KR); LEE, Jaechoon, Seoul 06772 (KR)
(74) Representative: Vossius & Partner Patentanwälte Rechtsanwälte mbB
(86) International application number: PCT/KR2024/009220
(87) International publication number: WO 2025/018643

(57) **Abstract**

The present disclosure is applicable to the technical field related to a display device, and for example, relates to a display device using a Light Emitting Diode (LED) and a manufacturing method thereof. A display device according to an embodiment of the present disclosure may include: a substrate; a plurality of light-emitting elements partitioned on the substrate to constitute a plurality of unit pixels; a black layer disposed between the individual light-emitting elements; an encapsulation layer formed on the substrate to cover the plurality of light-emitting elements; a first scattering layer disposed on the encapsulation layer and comprising first filler particles; a transparent layer disposed on the first scattering layer; and a second scattering layer disposed on the transparent layer and comprising second filler particles having a size larger than a size of the first filler particles.

## Description

### [Technical Field]

The present disclosure is applicable to the technical field related to a display device, and for example, relates to a display device using a Light Emitting Diode (LED) and a manufacturing method thereof.

### [Background Art]

As the information society develops, demands for display devices are increasing in various forms. In response to this, various display devices such as a Liquid Crystal Display (LCD), a Plasma Display Panel (PDP), an Electroluminescent Display (ELD), a Vacuum Fluorescent Display (VFD), an Organic Light Emitting Diode (OLED), and a Micro Light Emitting Diode (Micro-LED) have been recently researched and used.

Digital signage refers to a display device that provides specific information as well as broadcast programs in public places such as airports, hotels, hospitals, and subway stations as a communication tool that can induce not only general TV but also corporate marketing, advertising, training effects, and customer experience.

Digital signage is a medium for expressing various contents and commercial advertisements by installing display panels such as a Liquid Crystal Display (LCD), a Plasma Display Panel (PDP), an Organic Light Emitting Diode (OLED), and a Micro Light Emitting Diode (Micro-LED) in indoor or outdoor specific places or devices such as street furniture. It can be disposed in paths where the public moves, such as apartment elevators, subway stations, inside subways, inside buses, universities, banks, convenience stores, discount stores, and shopping malls, as well as homes.

Recently, as digital signage becomes larger and ultra-larger, many studies have been conducted to improve the image quality of display panels.

In particular, an optical layer for improving optical characteristics of a display panel may be provided, but distortion phenomena such as sparkling may occur due to a scattering material included in such an optical layer to reduce reflectance.

Accordingly, a way to solve these problems is emerging.

### [Invention]

### [Technical Problem]

According to an embodiment of the present disclosure, it is an object to provide a display device and a manufacturing method thereof that can prevent or reduce image quality degradation while providing a scattering layer of the display device.

Meanwhile, according to an embodiment of the present disclosure, it is an object to provide a display device and a manufacturing method thereof that can prevent or reduce a decrease in black feeling while providing a scattering layer of the display device.

### [Technical Solution]

A display device according to an embodiment of the present disclosure may include: a substrate; a plurality of light-emitting elements partitioned on the substrate to constitute a plurality of unit pixels; a black layer disposed between the individual light-emitting elements; an encapsulation layer formed on the substrate to cover the plurality of light-emitting elements; a first scattering layer disposed on the encapsulation layer and comprising first filler particles; a transparent layer disposed on the first scattering layer; and a second scattering layer disposed on the transparent layer and comprising second filler particles having a size larger than a size of the first filler particles.

A display device according to an embodiment of the present disclosure may include: a wiring substrate including a substrate, a plurality of light-emitting elements partitioned on the substrate to constitute a plurality of unit pixels, a black layer disposed between the individual light-emitting elements, and an encapsulation layer formed on the substrate to cover the plurality of light-emitting elements; a scattering layer disposed on the wiring substrate at a position corresponding to the unit pixel and comprising first filler particles; a transparent adhesive layer disposed on the scattering layer; and an AG coating layer disposed on the transparent adhesive layer and comprising second filler particles having a size larger than a size of the first filler particles.

A method of manufacturing a display device according to an embodiment of the present disclosure may include: providing a wiring substrate including a substrate, a plurality of light-emitting elements partitioned on the substrate to constitute a plurality of unit pixels, a black layer disposed between the individual light-emitting elements, and an encapsulation layer formed on the substrate to cover the plurality of light-emitting elements; forming a first scattering layer on the encapsulation layer, the first scattering layer comprising a first base material in which first filler particles are dispersed; providing an optical layer in which a second scattering layer comprising a second base material in which second filler particles having a size larger than a size of the first filler particles are dispersed is disposed on a first surface of a transparent base, and a transparent adhesive layer is disposed on a second surface of the transparent base; and attaching the transparent adhesive layer of the optical layer onto the first scattering layer.

### [Effect of the Invention]

According to exemplary embodiments of the present disclosure, the following effects are provided.

First, according to an embodiment of the present disclosure, it is possible to prevent image reflection (reflection phenomenon) of a display and simultaneously reduce image quality non-uniformity such as sparkling.

Meanwhile, by the action of the first scattering layer disposed near the pixels, it is possible to improve a light distribution non-uniformity phenomenon according to a viewing angle of the light-emitting element.

Meanwhile, according to an embodiment of the present disclosure, it is possible to prevent or reduce a decrease in black feeling while providing a scattering layer of the display device.

### [Description of Drawings]

FIG. 1 is a schematic cross-sectional view showing a display device according to a first embodiment of the present disclosure.
FIG. 2 is a schematic plan view showing a display device according to the first embodiment of the present disclosure.
FIG. 3 is a schematic cross-sectional view showing a display device according to a second embodiment of the present disclosure.
FIG. 4 is a schematic plan view showing a display device according to the second embodiment of the present disclosure.
FIG. 5 is a schematic cross-sectional view showing a display device according to a first comparative example.
FIG. 6 is a schematic plan view showing a display device according to the first embodiment of the present disclosure.
FIG. 7 is a schematic cross-sectional view showing a display device according to a second comparative example.
FIG. 8 and FIG. 9 are schematic diagrams showing display uniformity according to filler particle size.
FIG. 10 and FIG. 11 are graphs showing an effect of reducing an image quality non-uniformity phenomenon according to an embodiment of the present disclosure.
FIG. 12 is a graph showing a viewing angle improvement effect according to an embodiment of the present disclosure.
FIG. 13 is a graph showing luminance deviation by viewing angle according to an embodiment of the present disclosure.
FIG. 14 is a normalized graph of FIG. 13.
FIGS. 15 to 19 are schematic cross-sectional views showing a manufacturing method according to embodiments of the present disclosure.

### [Best Mode]

Hereinafter, embodiments disclosed in the present specification will be described in detail with reference to the accompanying drawings, but the same or similar components are assigned the same reference numerals regardless of the reference numerals, and redundant description thereof will be omitted. The suffixes "module" and "unit" for components used in the following description are given or used interchangeably only in consideration of ease of writing the specification, and do not themselves have distinct meanings or roles. In addition, in describing the embodiments disclosed in the present specification, if it is determined that a detailed description of related known technologies may obscure the gist of the embodiments disclosed in the present specification, the detailed description thereof will be omitted. In addition, it should be noted that the accompanying drawings are only for easy understanding of the embodiments disclosed in the present specification, and the technical spirit disclosed in the present specification should not be interpreted as being limited by the accompanying drawings.

Furthermore, although each drawing is described for convenience of description, it also falls within the scope of rights of the present disclosure for those skilled in the art to implement other embodiments by combining at least two or more drawings.

In addition, when an element such as a layer, region, or substrate is referred to as being "on" another component, it will be understood that it may be directly on the other element or intervening elements may be present therebetween.

The display device described in this specification is a concept including all display devices that display information with a unit pixel or a set of unit pixels. Therefore, it can be applied not only to finished products but also to parts. For example, a panel corresponding to a part of a digital TV also independently corresponds to a display device in this specification. Finished products may include mobile phones, smart phones, laptop computers, digital broadcasting terminals, personal digital assistants (PDA), portable multimedia players (PMP), navigation, slate PCs, tablet PCs, ultra books, digital TVs, desktop computers, and the like.

However, those skilled in the art will easily recognize that the configuration according to the embodiments described in this specification may be applied to devices capable of display, even in new product forms to be developed in the future.

In addition, the semiconductor light-emitting element mentioned in this specification is a concept including LEDs, mini-LEDs, micro-LEDs, and the like, and may be used interchangeably.

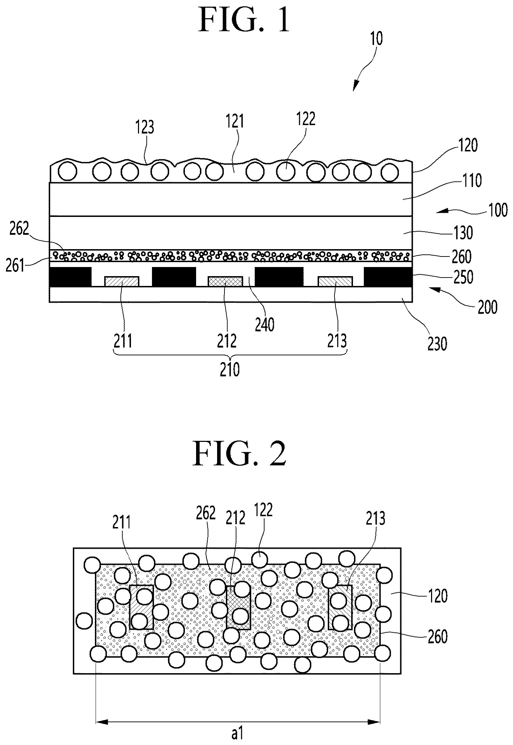

FIG. 1 is a schematic cross-sectional view showing a display device according to a first embodiment of the present disclosure. FIG. 2 is a schematic plan view showing a display device according to the first embodiment of the present disclosure.

As shown in FIG. 1, in a display device 10, an optical layer 100 may be provided on a wiring substrate 200 including unit pixels 210.

The wiring substrate 200 may implement an image by unit pixels 210 arranged on a substrate 230. An encapsulation layer 240 may be formed on sub-pixels 211, 212, and 213 constituting such a unit pixel 210. Although one unit pixel 210 including three sub-pixels 211, 212, and 213 is shown in FIG. 1, the wiring substrate 200 may include a large number of unit pixels 210.

The sub-pixels 211, 212, and 213 constituting the unit pixel 210 may be formed by light-emitting elements 211, 212, and 213. For example, the unit pixel 210 may include a first light-emitting element 211, a second light-emitting element 212, and a third light-emitting element 213. For example, the unit pixel 210 may include a red light-emitting element 211, a green light-emitting element 212, and a blue light-emitting element 213.

The red light-emitting element 211, the green light-emitting element 212, and the blue light-emitting element 213 constituting the unit pixel 210 may be electrically connected to electrode pads (not shown) arranged on the substrate 230. Here, the illustration of the electrode pads and wiring electrodes connecting the electrode pads is omitted.

The optical layer (optical film) 100 may be disposed on such a wiring substrate 200. The optical layer 100 may be composed of an optical film laminate. Hereinafter, the terms optical layer and optical film will be used interchangeably. The optical film 100 may be attached onto the wiring substrate 200. The wiring substrate 200 to which such an optical film 100 is attached may be referred to as a display device 10.

Although not separately shown, a modular display device in which a plurality of display devices 10 are combined to implement a wider display area may be implemented. For example, the display device 10 may be one display module constituting a modular display device. In this way, a plurality of display devices 10 may be combined in parallel to form a modular display device. A detailed description thereof will be omitted.

A black layer 250 may be disposed between light-emitting elements 211, 212, and 213 constituting individual sub-pixels. Such a black layer 250 may improve the black feeling of the display device 10. For example, the black layer 250 may cause the display device 10 to have a black color when the display device 10 is not driven. As another example, the black layer 250 may improve the contrast ratio of the display. Such a black layer 250 may have a pattern to occupy a certain area between the light-emitting elements 211, 212, and 213.

The encapsulation layer 240 may be disposed on the substrate 230 to cover the plurality of light-emitting elements 211, 212, and 213. Such an encapsulation layer 240 may be disposed on the upper surface of the substrate 230 where the plurality of light-emitting elements 211, 212, and 213 and the black layer 250 are formed to planarize the upper surface of the substrate 230.

In this way, the encapsulation layer 240 may be disposed on the upper surface of the substrate 230 provided with electrode pads (not shown). The encapsulation layer 240 is made of an insulating and flexible material such as polyimide (PI), PET, PEN, or the like, and may be formed integrally with the substrate 230 to form one substrate. In this way, the substrate 230 provided with electrode pads may form the wiring substrate 200 in which wiring electrodes (not shown) are connected to the electrode pads.

As described above, unit pixels of such a wiring substrate 200 may be implemented by light-emitting elements. In the embodiment of the present disclosure, a light emitting diode (LED) is exemplified as one type of semiconductor light-emitting element that converts current into light.

The substrate 230 may include glass or polyimide (PI). In order to implement a flexible display, the substrate 230 may be any insulating and flexible material, such as polyethylene naphthalate (PEN), polyethylene terephthalate (PET), or the like. In addition, the substrate 230 may be either a transparent material or an opaque material.

The semiconductor light-emitting elements 211, 212, and 213 constituting the unit pixel may be micro-LEDs having a size of several to hundreds of micrometers. In some cases, the semiconductor light-emitting elements 211, 212, and 213 may be mini-LEDs having a size several tens of times larger than micro-LEDs. Here, the mini-LED may have a different stacked structure from the micro-LED in addition to the size. Specifically, the mini-LED may further include a growth substrate for growing semiconductor layers.

As an example of the semiconductor light-emitting elements 211, 212, and 213 constituting the unit pixel, micro-LEDs or mini-LEDs may have a stacked LED type composed of red (R), green (G), and blue (B) layers in one LED, as well as a type in which red (R), green (G), and blue (B) LEDs independently emit light.

A scattering layer 260 comprising filler particles 262 may be disposed on the encapsulation layer 240. Such a scattering layer (hereinafter, a first scattering layer) 260 may be provided with filler particles (hereinafter, first filler particles) 262 dispersed in a base material (hereinafter, a first base material) 261.

The first filler particles 262 may have a function of having optical characteristics in the display device 10. Here, the optical characteristics may be characteristics of refracting or scattering light emitted from the light-emitting elements 211, 212, and 213.

Light emitted from the light-emitting elements 211, 212, and 213 may be refracted or scattered in the first scattering layer 260 comprising the first filler particles 262. Light scattered by the first filler particles 262 may be emitted toward the upper optical layer 100.

The optical layer 100 may be disposed on the first scattering layer 260. The optical layer 100 may include a second scattering layer 120 on transparent layers 130 and 110.

The second scattering layer 120 may include filler particles (hereinafter, second filler particles) 122 having a size larger than the first filler particles 262. The second scattering layer 120 may include the second filler particles 122 in a base material 121. For example, the second scattering layer 120 may be provided with second filler particles 122 dispersed in the base material 121. The base material 121 may include a transparent resin material. In this way, the second filler particles 122 may be dispersed in the transparent resin material constituting the base material 121 and disposed on a transparent base 110.

Here, the transparent base 110 may include an insulating material such as PET, PEN, or the like while being transparent.

The transparent base 110 may be disposed on the first scattering layer 260 by a transparent adhesive layer (optically clear adhesive; OCA) 130. For example, the transparent adhesive layer 130 may be disposed between the transparent base 110 and the first scattering layer 260 to adhere them to each other.

As an exemplary embodiment, the second filler particles 122 may have a size approximately 10 times larger than the size of the first filler particles 262. Here, the size may mean the diameter of the filler particles 122 and 262 when the filler particles 122 and 262 have a spherical shape. Meanwhile, for example, when the filler particles 122 and 262 have an amorphous shape, it may mean the length of the long side. In addition, the size here may mean the average size of the filler particles 122 and 262.

For example, the second scattering layer 120 may be disposed on the outside of the optical layer 100 and function as an anti-glare (AG) layer. That is, it may be said that the second scattering layer 120 performs a function of scattering external light. Such a second scattering layer 120 may form a rough surface 123 on the surface of the optical layer 100 to prevent external light from being reflected uniformly.

Meanwhile, the rough surface 123 of the second scattering layer 120 may significantly lower the rate at which total internal reflection occurs in the optical layer 100. The second filler particles 122 included in the second scattering layer 120 may provide the rough surface 123 to the surface of the optical layer 100. At least a portion of the light emitted from the light-emitting elements 211, 212, and 213 may be scattered by the second filler particles 122.

For example, the size of such second filler particles 122 may be 3 to 6 µm. The second filler particles 122 may include at least one of Zr, Si, Ti, Zn, BaS, or oxide thereof. For example, the second filler particles 122 may be made of at least one of Zr, Si, Ti, Zn, BaS, or oxide thereof. For example, the second filler particles 122 may be formed of ZrO₂ or TiO₂ (high refractive material). As another example, the second filler particles 122 may be formed of Hollow SiO₂ (low refractive material).

The first scattering layer 260 may include the first filler particles 262 in the base material 261. For example, the first scattering layer 260 may be provided with first filler particles 262 dispersed in the base material 261. The base material 261 may include a transparent resin material. In this way, the first filler particles 262 may be dispersed in the transparent resin material constituting the base material 261 and coated on the encapsulation layer 240.

For example, the size of such first filler particles 262 may be 1 µm or less. For example, the size of the first filler particles 262 may be 300 to 800 nm.

The first filler particles 262 may include at least one of Zr, Si, Ti, Zn, BaS, or oxide thereof. For example, the first filler particles 262 may be made of at least one of Zr, Si, Ti, Zn, BaS, or oxide thereof. For example, when the first filler particles 262 are formed of a high refractive material, they may be formed of ZrO₂ or TiO₂. As another example, when the first filler particles 262 are formed of a low refractive material, they may be formed of Hollow SiO₂.

For example, the content of the first filler particles 262 may be greater than 0 and 50% by mass or less relative to the first scattering layer 260. As a specific example, the content of the first filler particles 262 may be greater than 0 and 30% by mass or less relative to the first scattering layer 260. In the case that the first filler particles 262 exist, they may exhibit an effect as a scattering layer, but the content thereof may be adjusted. For example, in the case that the content of the first filler particles 262 is greater than this, light efficiency may decrease. Meanwhile, in the case that the content of the first filler particles 262 is greater than this, the formation of the first scattering layer 260 may not be easy.

As mentioned above, the second filler particles 122 may have a size approximately 10 times larger than the size of the first filler particles 262. As a more specific example, the second filler particles 122 may have a size 3.5 to 20 times larger than the size of the first filler particles 262. As another example, the size ratio of the first filler particles 262 to the second filler particles 122 may be 0.05 to 0.15. As described above, the second filler particles 122 may implement the roughness of the AG layer. Meanwhile, the first filler particles 262 may act so that light emitted from the light-emitting elements 211, 212, and 213 may be evenly scattered in an area larger than the light-emitting elements 211, 212, and 213.

Referring to FIG. 2, the first scattering layer 260 may have an area corresponding to the unit pixel 210. For example, the first scattering layer 260 may have an area (first area; a1) or width corresponding to the first light-emitting element 211, the second light-emitting element 212, and the third light-emitting element 213. More specifically, the first scattering layer 260 may have an area (a1) covering the entire first light-emitting element 211, second light-emitting element 212, and third light-emitting element 213. In such a first scattering layer 260, light emitted from the first light-emitting element 211, the second light-emitting element 212, and the third light-emitting element 213 is evenly scattered and spread to about the size of the first area (a1) to be emitted upward.

The pixel arrangement of the display device 10 tends to become gradually higher in definition, and even in the case of a display such as signage, micro-LEDs having a side length of several to several tens of micrometers (µm) are used as pixels. For example, the size of the light-emitting elements 211, 212, and 213 may have a short side length of 20 µm.

At this time, when only the second scattering layer 120 that may function as an AG film is provided, the size of the second filler particles 122 included in such a second scattering layer 120 is about 3 to 6 µm, and the size of these second filler particles 122 may be relatively large considering the size of the light-emitting elements 211, 212, and 213 used as light sources. Accordingly, a large deviation occurs in the number and distribution form of the second filler particles 122 per light-emitting area, which may cause image quality non-uniformity. For example, a sparkling phenomenon may occur on the display screen.

However, according to the embodiment of the present disclosure, a scattering layer (first scattering layer; 260) having relatively small sized filler particles (first filler particles; 262) is disposed near the pixel 210, and a second scattering layer 120 comprising second filler particles 122 is provided on top of the optical layer 100 to prevent image reflection (reflection phenomenon) of the display and simultaneously reduce image quality non-uniformity such as sparkling.

Meanwhile, by the action of the first scattering layer 260 disposed near the pixel 210, it is possible to improve a light distribution non-uniformity phenomenon according to a viewing angle of the light-emitting elements 211, 212, and 213.

The effects according to such embodiments of the present disclosure will be described in detail later.

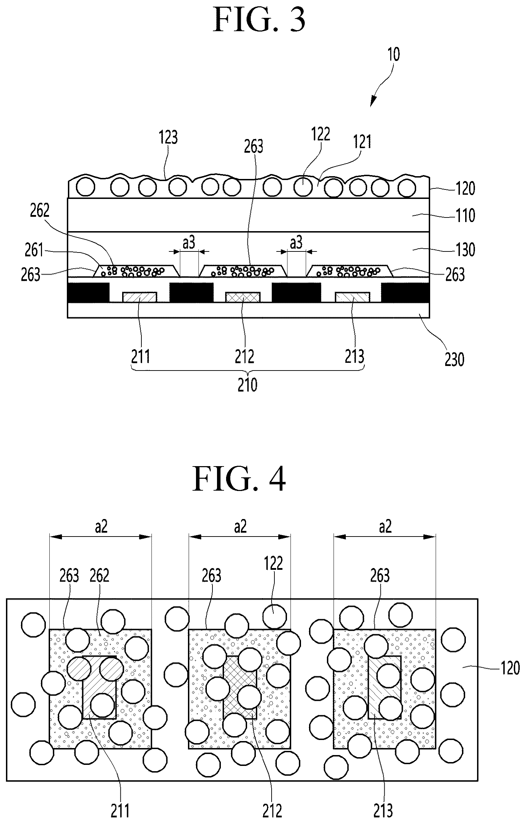

FIG. 3 is a schematic cross-sectional view showing a display device according to a second embodiment of the present disclosure. FIG. 4 is a schematic plan view showing a display device according to the second embodiment of the present disclosure.

Referring to FIG. 3, in the display device 10, the optical layer 100 may be provided on a wiring substrate 200 including unit pixels 210.

The wiring substrate 200 may implement an image by unit pixels 210 arranged on a substrate 230. The encapsulation layer 240 may be formed on sub-pixels 211, 212, and 213 constituting such a unit pixel 210.

The sub-pixels 211, 212, and 213 constituting the unit pixel 210 may be formed by light-emitting elements 211, 212, and 213. For example, the unit pixel 210 may include a first light-emitting element 211, a second light-emitting element 212, and a third light-emitting element 213. For example, the unit pixel 210 may include a red light-emitting element 211, a green light-emitting element 212, and a blue light-emitting element 213. Although one unit pixel 210 including three sub-pixels 211, 212, and 213 is shown in FIG. 3, the wiring substrate 200 may include a large number of unit pixels 210.

The red light-emitting element 211, the green light-emitting element 212, and the blue light-emitting element 213 constituting the unit pixel 210 may be electrically connected to electrode pads (not shown) arranged on the substrate 230. Here, the illustration of the electrode pads and wiring electrodes connecting the electrode pads is omitted.

The optical layer (optical film) 100 may be disposed on such a wiring substrate 200. The optical layer 100 may include an optical film laminate. Hereinafter, the terms optical layer and optical film will be used interchangeably. The optical film 100 may be attached onto the wiring substrate 200. The wiring substrate 200 to which such an optical film 100 is attached may be referred to as a display device 10.

Although not separately shown, a modular display device in which a plurality of display devices 10 are combined to implement a wider display area may be implemented. For example, the display device 10 may be one display module constituting a modular display device. In this way, a plurality of display devices 10 may be combined in parallel to form a modular display device. A detailed description thereof will be omitted.

The black layer 250 may be disposed between light-emitting elements 211, 212, and 213 constituting individual sub-pixels. The black layer 250 may improve the black feeling of the display device 10. For example, the black layer 250 may cause the display device 10 to have a black color when the display device 10 is not driven. As another example, the black layer 250 may improve the contrast ratio of the display. Such a black layer 250 may have a pattern to occupy a certain area between the light-emitting elements 211, 212, and 213.

The encapsulation layer 240 may be disposed on the substrate 230 to cover the plurality of light-emitting elements 211, 212, and 213. The encapsulation layer 240 may be disposed on the upper surface of the substrate 230 where the plurality of light-emitting elements 211, 212, and 213 and the black layer 250 are formed to planarize the upper surface of the substrate 230.

As described above, the general configuration of the wiring substrate 200 and the optical layer 100 according to the present embodiment may be the same as the first embodiment described above. Hereinafter, redundant descriptions will be omitted, and the description will focus on characteristic configurations in the present embodiment.

The substrate 230 may include glass or polyimide (PI). In order to implement a flexible display, the substrate 230 may be any insulating and flexible material, such as PEN, PET, or the like. In addition, the substrate 230 may be either a transparent material or an opaque material.

The semiconductor light-emitting elements 211, 212, and 213 constituting the unit pixel may be micro-LEDs having a size of several to hundreds of micrometers.

A scattering layer 263 including filler particles 262 may be disposed on the encapsulation layer 240. Such a scattering layer (hereinafter, a first scattering layer; 263) may be provided with filler particles (hereinafter, first filler particles; 262) dispersed in a base material (hereinafter, a first base material; 261).

The first filler particles 262 may have a function of having optical characteristics in the display device 10. Here, the optical characteristics may be characteristics of refracting or scattering light emitted from the light-emitting elements 211, 212, and 213.

Here, the first scattering layer 263 according to the present embodiment may have an area (a2; hereinafter, a second area) or width corresponding to each light-emitting element.

The optical layer 100 may be disposed on the first scattering layer 263. The optical layer 100 may include a second scattering layer 120 on transparent layers 130 and 110.

The second scattering layer 120 may include filler particles (hereinafter, second filler particles) 122 having a size larger than the first filler particles 262. The second scattering layer 120 may include the second filler particles 122 in a base material 121. For example, the second scattering layer 120 may be provided with second filler particles 122 dispersed in the base material 121. The base material 121 may include a transparent resin material. In this way, the second filler particles 122 may be dispersed in the transparent resin material constituting the base material 121 and disposed on the transparent base 110.

The transparent base 110 may be disposed on the first scattering layer 263 by a transparent adhesive layer (optically clear adhesive; OCA) 130. For example, the transparent adhesive layer 130 may be disposed between the transparent base 110 and the first scattering layer 263 to adhere them to each other.

Since the transparent adhesive layer 130 has elasticity before being cured, it may cover and planarize the first scattering layer 263 having a pattern.

As an exemplary embodiment, the second filler particles 122 may have a size approximately 10 times larger than the size of the first filler particles 262. Here, the size may mean the diameter of the filler particles 122 and 262 when the filler particles 122 and 262 have a spherical shape. Meanwhile, for example, when the filler particles 122 and 262 have an amorphous shape, it may mean the length of the long side.

For example, the second scattering layer 120 may be disposed on the outside of the optical layer 100 and function as an anti-glare (AG) layer. That is, it may be said that the second scattering layer 120 performs a function of scattering external light. Such a second scattering layer 120 may form a rough surface 123 on the surface of the optical layer 100 to prevent external light from being reflected uniformly.

For example, the size of such second filler particles 122 may be 3 to 6 µm. The second filler particles 122 may include at least one of Zr, Si, Ti, Zn, BaS, or oxide thereof. For example, the second filler particles 122 may be made of at least one of Zr, Si, Ti, Zn, BaS, or oxide thereof. For example, the second filler particles 122 may be formed of ZrO₂ or TiO₂ (high refractive material). As another example, the second filler particles 122 may be formed of Hollow SiO₂ (low refractive material).

The characteristics of the second scattering layer 120 as described above may be the same as the first embodiment described above.

The first scattering layer 263 may include the first filler particles 262 in the base material 261. For example, the first scattering layer 263 may be provided with first filler particles 262 dispersed in the base material 261. The base material 261 may include a transparent resin material. In this way, the first filler particles 262 may be dispersed in the transparent resin material constituting the base material 261 and coated on the encapsulation layer 240.

For example, the size of such first filler particles 262 may be 1 µm or less. For example, the size of the first filler particles 262 may be 300 to 800 nm.

The first filler particles 262 may include at least one of Zr, Si, Ti, Zn, BaS, or oxide thereof. For example, the first filler particles 262 may be made of at least one of Zr, Si, Ti, Zn, BaS, or oxide thereof. For example, when the first filler particles 262 are formed of a high refractive material, they may be formed of ZrO₂ or TiO₂. As another example, when the first filler particles 262 are formed of a low refractive material, they may be formed of Hollow SiO₂.

For example, the content of the first filler particles 262 may be greater than 0 and 50% by mass or less relative to the first scattering layer 263. As a specific example, the content of the first filler particles 262 may be greater than 0 and 30% by mass or less relative to the first scattering layer 263. In the case that the first filler particles 262 exist, they may exhibit an effect as a scattering layer, but the content thereof may be adjusted. For example, in the case that the content of the first filler particles 262 is greater than this, light efficiency may decrease. Meanwhile, in the case that the content of the first filler particles 262 is greater than this, the formation of the first scattering layer 263 may not be easy.

As mentioned above, the second filler particles 122 may have a size approximately 10 times larger than the size of the first filler particles 262. As a more specific example, the second filler particles 122 may have a size 3.5 to 20 times larger than the size of the first filler particles 262. As another example, the size ratio of the first filler particles 262 to the second filler particles 122 may be 0.05 to 0.15. As described above, the second filler particles 122 may implement the roughness of the AG layer. Meanwhile, the first filler particles 262 may act so that light emitted from the light-emitting elements 211, 212, and 213 may be evenly scattered in an area larger than the light-emitting elements 211, 212, and 213.

As mentioned above, referring to FIG. 4, the first scattering layer 263 may have an area (a2; hereinafter, a second area) or width corresponding to each light-emitting element. That is, the first scattering layer 263 may have an area (a2) covering each of the first light-emitting element 211, the second light-emitting element 212, and the third light-emitting element 213.

In the first scattering layer 263, light emitted from the first light-emitting element 211, the second light-emitting element 212, and the third light-emitting element 213 is each evenly scattered and spread to about the size of the second area (a2) to be emitted upward.

In this way, the first scattering layer 263 having a pattern corresponding to the first light-emitting element 211, the second light-emitting element 212, and the third light-emitting element 213 may be disposed at a certain interval (first interval; a3) from each other.

Substantially, the area (a2) or width of the first scattering layer 263 may correspond to the area or width between two adjacent black layers 250 disposed on both sides of the corresponding light-emitting element 211, 212, 213. For example, the area (a2) or width of the first scattering layer 263 may coincide with or be larger than the space between two adjacent black layers 250 disposed on both sides of the corresponding light-emitting element 211, 212, 213.

By the interval (a3) between such first scattering layers 263, the black layer 250 disposed between two adjacent light-emitting elements may be opened. From a display perspective, in this way, the first scattering layer 263 scatters light emitted from the light-emitting elements 211, 212, and 213 while the black layer 250 is opened, so that a decrease in black feeling or contrast ratio of the display caused by the first scattering layer 263 may be prevented.

According to the embodiment of the present disclosure, a scattering layer (first scattering layer; 263) having relatively small sized filler particles (first filler particles; 262) is patterned and disposed to correspond to the positions of individual light-emitting elements 211, 212, and 213 near the pixel 210, and a second scattering layer 120 comprising second filler particles 122 is provided on top of the optical layer 100 to prevent image reflection (reflection phenomenon) of the display and simultaneously reduce image quality non-uniformity such as sparkling. Along with this, a decrease in black feeling or contrast ratio of the display caused by the scattering layer 263 may be minimized.

Meanwhile, by the action of the first scattering layer 263 disposed near the pixel 210, it is possible to improve a light distribution non-uniformity phenomenon according to a viewing angle of the light-emitting elements 211, 212, and 213.

The effects according to such embodiments of the present disclosure will be described in detail later.

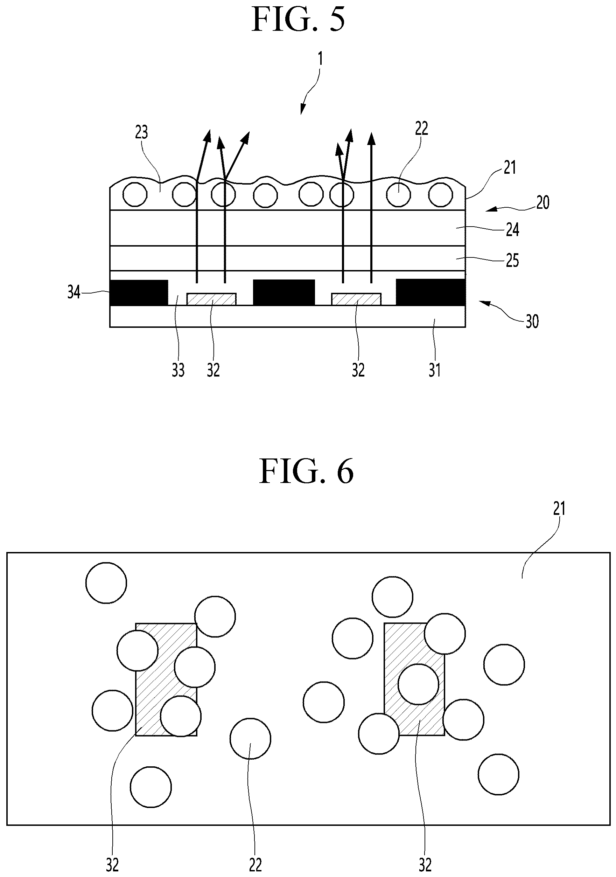

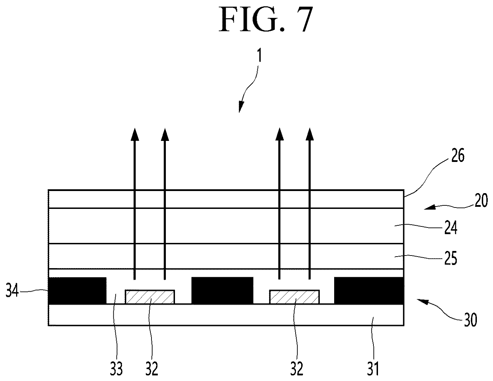

FIG. 5 is a schematic cross-sectional view showing a display device according to a first comparative example. FIG. 6 is a schematic plan view showing a display device according to the first embodiment of the present disclosure. FIG. 7 is a schematic cross-sectional view showing a display device according to a second comparative example.

As described above, the pixel arrangement of the display device 1 tends to become gradually higher in definition, and even in the case of a display such as signage, micro-LEDs having a side length of several to several tens of micrometers (µm) are used as pixels.

FIG. 5 shows a first comparative example, where in a wiring substrate 30, a light-emitting element 32 and a black layer 34 are disposed on a substrate 31, an encapsulation layer 33 is included, and an optical layer 20 provided with an AG film 21 is disposed on such a wiring substrate 30. Such an AG film 21 is disposed on a transparent base 24 and may be attached to the wiring substrate 30 by a transparent adhesive layer 25.

At this time, as in the first comparative example shown in FIG. 5, when only the AG film 21 (or scattering layer) is provided, the size of the filler particles 22 included in such a scattering layer 21 is about 3 to 6 µm, and the size of these filler particles 22 may be relatively large considering the size of the light-emitting element 32 used as a light source (refer to FIG. 6). Accordingly, a large deviation occurs in the number and distribution form of the filler particles 22 per light-emitting area, which may cause image quality non-uniformity. For example, a sparkling phenomenon may occur on the display screen.

This sparkling phenomenon means a phenomenon in which the display screen does not look smooth due to the relatively large sized filler particles 22.

Meanwhile, as in the second comparative example shown in FIG. 7, when a film 26 that does not include filler particles 22 is provided, the display screen may be formed smoothly, but an image reflection phenomenon occurs in which external light is reflected on the display surface. Accordingly, mirror-like reflection occurs on the display surface, which may reduce display visibility.

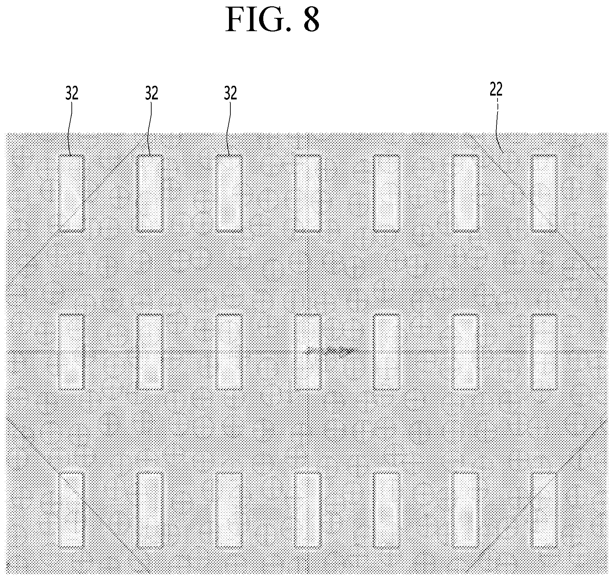

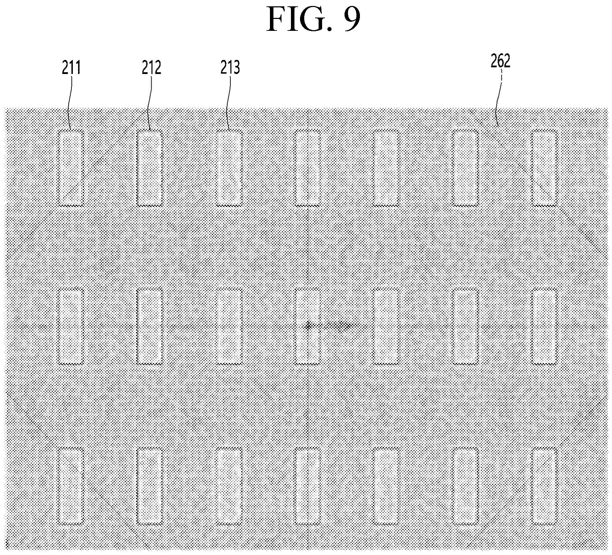

FIG. 8 and FIG. 9 are schematic diagrams showing display uniformity according to filler particle size.

FIG. 8 shows a luminance map in the case of having a conical particle structure with a size of 50 µm and an angle of 10° on a display light-emitting surface formed by light-emitting elements 211, 212, and 213. In addition, FIG. 9 shows a luminance map in the case of having a conical particle structure with a size of 10 µm and an angle of 10° on a display light-emitting surface formed by light-emitting elements 211, 212, and 213.

For example, the light-emitting map of FIG. 8 may correspond to the first comparative example, and the light-emitting map of FIG. 9 may correspond to the first embodiment or the second embodiment of the present disclosure.

In FIG. 8, the shading on each light-emitting element 32 represents a pattern in which light emitted from each light-emitting element 32 is scattered by filler particles 22.

Meanwhile, in FIG. 9, the shading on each light-emitting element 211, 212, 213 represents a pattern in which light emitted from each light-emitting element 211, 212, 213 is scattered by the filler particles 262.

In FIG. 9, it may be seen that the shading pattern occurs substantially evenly on each light-emitting element 211, 212, and 213. However, in FIG. 8, it may be seen that deviations occur in these shading patterns on each light-emitting element 32.

In this way, it may be seen that it is advantageous for the size of the filler particles 262 used as a scattering material in a display to have a relatively small size.

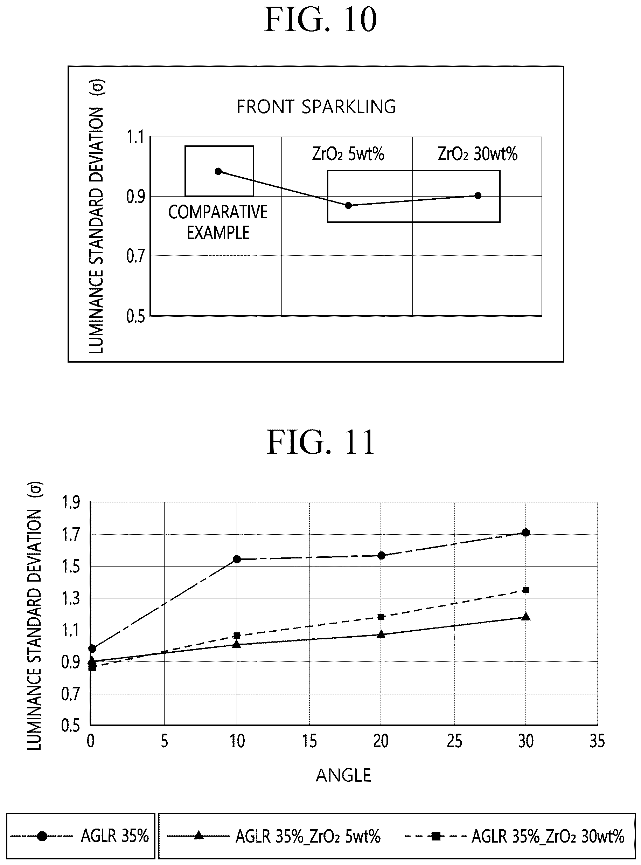

FIG. 10 and FIG. 11 are graphs showing an effect of reducing an image quality non-uniformity phenomenon according to an embodiment of the present disclosure.

FIG. 10 shows a luminance standard deviation (σ) at a front angle of a display screen according to a comparative example (first comparative example) and an embodiment of the present disclosure. That is, FIG. 10 shows the luminance standard deviation (σ) when the display is viewed from the front.

In the embodiment of the present disclosure, ZrO₂ is used as the first filler particles 262 in the first scattering layer 260, and the luminance standard deviation (σ) is shown when the content of these first filler particles 262 is 5 wt% (weight ratio) and 30 wt%, respectively.

In this way, when viewed from the front of the display, according to the embodiment of the present disclosure, it may be seen that sparkling is reduced compared to the first comparative example.

Referring to FIG. 10, the luminance standard deviation may be smaller when 5 wt% of the first filler particles 262 is used, but the light scattering effect may be better when 30 wt% of the first filler particles 262 is used.

Here, data is shown for the case where the size of the first filler particles 262 is 500 nm. Here, the size of the first filler particles 262 may mean an average particle size. The size of the first filler particles 262 may be identically applied to the following description.

FIG. 11 shows the luminance standard deviation (σ) at a side angle of a display screen according to a comparative example (first comparative example) and an embodiment of the present disclosure. That is, FIG. 11 shows the luminance standard deviation (σ) according to a side angle when the display is viewed from the side.

Here, data labeled AGLR 35% represents the result according to the first comparative example. Here, it represents that the content of the scattering agent is 35 wt%.

In addition, data labeled AGLR 35%_ZrO₂ 5wt% corresponds to a case where ZrO₂ is used as the first filler particles 262 in the first scattering layer 260 in the embodiment of the present disclosure, and the content of these first filler particles 262 is 5 wt% (weight ratio). Meanwhile, data labeled AGLR 35%_ZrO₂ 30wt% corresponds to a case where ZrO₂ is used as the first filler particles 262 in the first scattering layer 260 in the embodiment of the present disclosure, and the content of these first filler particles 262 is 30 wt% (weight ratio).

Referring to FIG. 11, in the case of the first comparative example, it may be seen that the luminance deviation significantly increases according to the angle. At this time, it may be seen that the luminance deviation sharply increases at an angle of about 10 degrees.

On the other hand, according to the embodiment of the present disclosure, it may be confirmed that the luminance deviation does not significantly increase according to the angle in both cases.

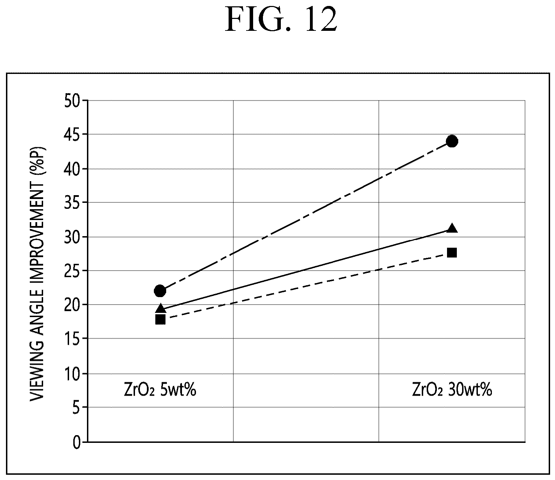

FIG. 12 is a graph showing a viewing angle improvement effect according to an embodiment of the present disclosure.

Referring to FIG. 12, a viewing angle improvement effect is shown for the case where 5 wt% of ZrO₂ is used as the first filler particles 262 in the first scattering layer 260 and the case where 30 wt% of ZrO₂ is used as the first filler particles 262 in the embodiment of the present disclosure.

Referring to FIG. 10 and FIG. 11 above, it may be seen that the case using 5 wt% of ZrO₂ is superior in terms of luminance standard deviation, but considering the luminance standard deviation at a viewing angle of 60°, the viewing angle improvement effect is superior in the case using 30 wt% of ZrO₂.

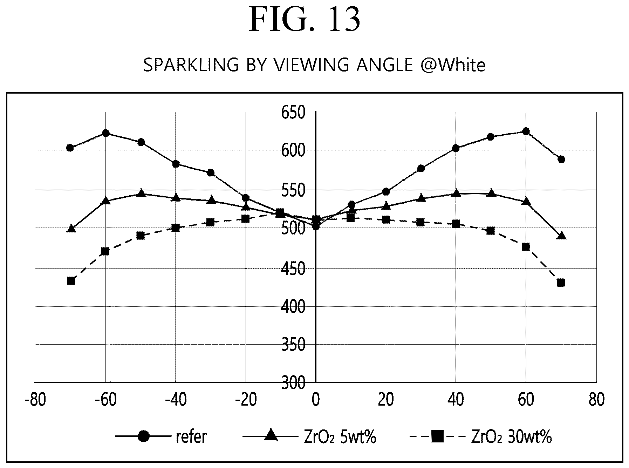

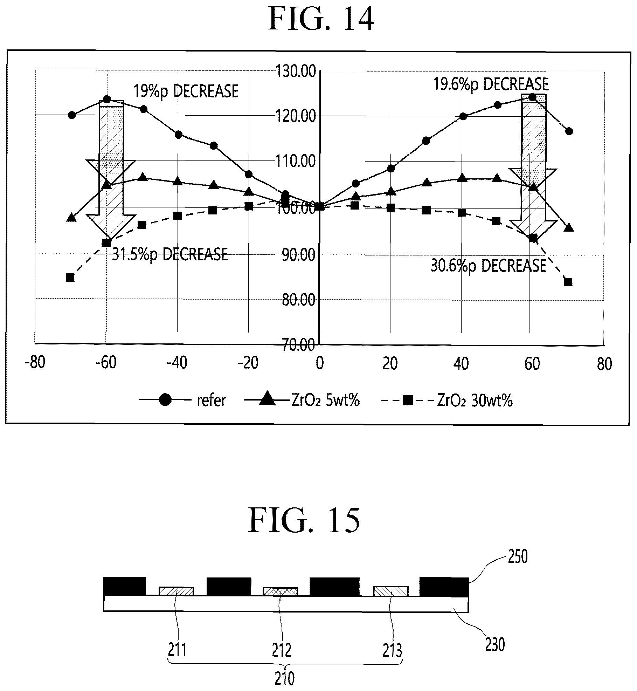

FIG. 13 is a graph showing luminance deviation by viewing angle according to an embodiment of the present disclosure. FIG. 14 is a normalized graph of FIG. 13.

Referring to FIG. 13, considering the luminance standard deviation (vertical axis) by viewing angle for white light, it may be seen that the case according to the embodiment of the present disclosure is superior to the case according to the first comparative example (refer) in terms of luminance standard deviation by viewing angle.

According to the result shown by normalizing the case of FIG. 13, it may be confirmed that the luminance standard deviation at a viewing angle of 60° decreased by 19 percentage points in the case of using 5 wt% of ZrO₂ compared to the first comparative example. In addition, it may be confirmed that the luminance standard deviation further decreased by 31.5 percentage points in the case of using 30 wt% of ZrO₂ compared to the case of using 5 wt% of ZrO₂.

As described above, it may be seen that when ZrO₂ is used as the first filler particles 262, the luminance standard deviation decreases as the content increases. Accordingly, it may be seen that image quality uniformity improves as the content of the first filler particles 262 increases. Meanwhile, as mentioned above, the content of these first filler particles 262 may be used at 50 wt% or less.

FIGS. 15 to 19 are schematic cross-sectional views showing a manufacturing method according to embodiments of the present disclosure.

Hereinafter, with reference to FIGS. 15 to 19, a manufacturing method according to embodiments of the present disclosure will be described step by step.

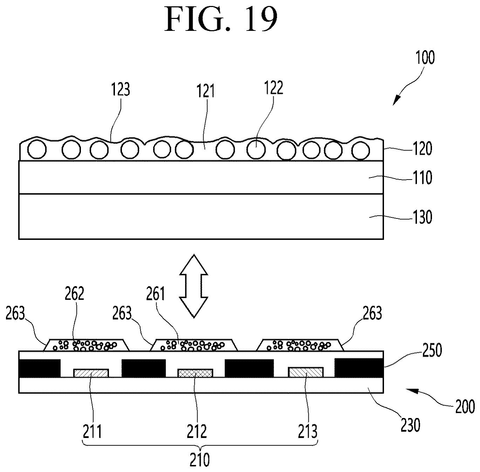

Such a manufacturing method according to embodiments of the present disclosure may largely include a step of providing a wiring substrate 200, a step of providing an optical layer 100, and a step of bonding the wiring substrate 200 and the optical layer 100 (FIG. 19).

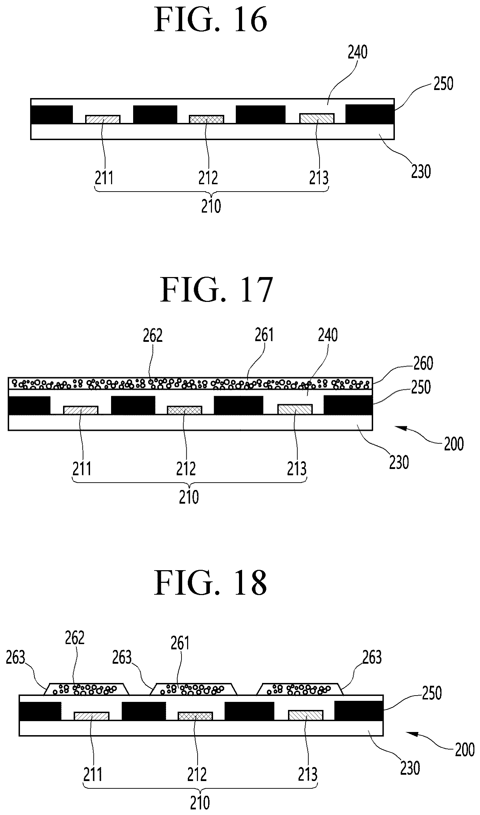

First, referring to FIG. 15 and FIG. 16, a process of providing a wiring substrate 200 including a substrate 230, the plurality of light-emitting elements 211, 212, and 213 partitioned on the substrate 230 to constitute the plurality of unit pixels 210, a black layer 250 disposed between individual light-emitting elements 211, 212, and 213, and an encapsulation layer 240 formed on the substrate 230 to cover the plurality of light-emitting elements 211, 212, and 213 may be performed.

For example, referring to FIG. 15, a plurality of light-emitting elements 211, 212, and 213 constituting a plurality of unit pixels 210 and a black layer 250 disposed between individual light-emitting elements 211, 212, and 213 may be formed on a substrate 230.

Thereafter, referring to FIG. 16, an encapsulation layer 240 formed on the substrate 230 to cover the plurality of light-emitting elements 211, 212, and 213 may be formed.

Next, referring to FIG. 17, according to a first embodiment, the first scattering layer 260 comprising the first base material 261 in which first filler particles 262 are dispersed may be formed on the encapsulation layer 240.

The first scattering layer 260 may have an area (a1) corresponding to the unit pixel 210.

The first scattering layer 260 may be formed by at least one process of screen printing, slit coating, spin coating, dot printing, or film lamination. Meanwhile, the second scattering layer 120 may also be formed by at least one process of screen printing, slit coating, spin coating, dot printing, or film lamination.

Meanwhile, referring to FIG. 18, according to a second embodiment, the first scattering layer 263 comprising the first base material 261 in which the first filler particles 262 are dispersed may be formed on the encapsulation layer 240.

The first scattering layer 263 may have an area (a2) corresponding to the unit light-emitting elements 211, 212, and 213. For example, the first scattering layer 263 may have an area (a2) locally covering each individual light-emitting element 211, 212, 213. That is, the first scattering layer 263 may be provided by being divided from each other with a first interval (a3).

Referring to FIG. 19, the optical layer 100 may be prepared, which includes the second scattering layer 120 including the second base material 121 in which second filler particles 122 having a size larger than the first filler particles 262 are dispersed on one surface of the transparent base 110, and the transparent adhesive layer 130 on the other surface of the transparent base 110.

The process of providing the wiring substrate 200 and the process of providing the optical layer 100 may be performed independently of each other.

The optical layer 100 may be bonded onto such a wiring substrate 200 so that the transparent adhesive layer 130 faces the wiring substrate 200. In this way, when the wiring substrate 200 and the optical layer 100 are bonded, the display device 10 according to the second embodiment described with reference to FIG. 3 and FIG. 4 may be manufactured. Meanwhile, the optical layer 100 may be bonded to the wiring substrate 200 in the state shown in FIG. 17 to manufacture the display device 10 according to the first embodiment.

The features, structures, effects, and the like, described in the embodiments above are included in at least one embodiment of the present disclosure, and are not necessarily limited to only one embodiment. Furthermore, the features, structures, effects, and the like, exemplified in each embodiment may be combined or modified for other embodiments by those having ordinary knowledge in the field to which the embodiments belong. Therefore, contents related to such combinations and modifications should be interpreted as being included in the scope of the present disclosure.

In addition, although described centered on embodiments above, these are merely examples and do not limit the present disclosure, and those having ordinary knowledge in the field to which the present disclosure belongs will know that various modifications and applications not exemplified above are possible within a range that does not depart from the essential characteristics of the present embodiment. For example, each component specifically shown in the embodiments may be modified and implemented. And differences related to such modifications and applications should be interpreted as being included in the scope of the present disclosure defined in the attached claims.

### [Industrial Applicability]

According to the present disclosure, a display device using a Light Emitting Diode (LED) and a manufacturing method thereof can be provided.

## Claims

1. A display device comprising:
a substrate;
a plurality of light-emitting elements partitioned on the substrate to constitute a plurality of unit pixels;
a black layer disposed between the individual light-emitting elements;
an encapsulation layer formed on the substrate to cover the plurality of light-emitting elements;
a first scattering layer disposed on the encapsulation layer and including first filler particles;
a transparent layer disposed on the first scattering layer; and
a second scattering layer disposed on the transparent layer and including second filler particles having a size larger than a size of the first filler particles.

2. The display device of claim 1, wherein the second scattering layer is disposed on a transparent base.

3. The display device of claim 1, wherein the transparent base is adhered to the encapsulation layer by a transparent adhesive layer.

4. The display device of claim 1, wherein a size ratio of the first filler particles to the second filler particles is 0.05 to 0.15.

5. The display device of claim 1, wherein the first filler particles comprise at least one of Zr, Si, Ti, Zn, BaS, or oxide thereof.

6. The display device of claim 1, wherein a content of the first filler particles is greater than 0 and 50% by mass or less relative to the first scattering layer.

7. The display device of claim 1, wherein a size of the first filler particles is 300 to 800 nm.

8. The display device of claim 1, wherein the first scattering layer has an area corresponding to the unit pixel.

9. The display device of claim 1, wherein the first scattering layer has an area corresponding to the individual light-emitting element.

10. The display device of claim 9, wherein each first scattering layer is disposed with a first interval.

11. The display device of claim 10, wherein the first interval defines a width at which the black layer is opened.

12. A method of manufacturing a display device, comprising:
providing a wiring substrate including a substrate, a plurality of light-emitting elements partitioned on the substrate to constitute a plurality of unit pixels, a black layer disposed between the individual light-emitting elements, and an encapsulation layer formed on the substrate to cover the plurality of light-emitting elements;
forming a first scattering layer on the encapsulation layer, the first scattering layer comprising a first base material in which first filler particles are dispersed;
providing an optical layer including a second scattering layer comprising a second base material in which second filler particles having a size larger than a size of the first filler particles are dispersed, the second scattering layer being disposed on a first surface of a transparent base, and a transparent adhesive layer disposed on a second surface of the transparent base; and
attaching the transparent adhesive layer of the optical layer onto the first scattering layer.

13. The method of claim 12, wherein the providing of the wiring substrate and the providing of the optical layer are performed independently.

14. The method of claim 12, wherein the forming of the first scattering layer is performed to have an area locally covering the individual light-emitting element.

15. The method of claim 12, wherein the forming of the first scattering layer is performed to have an area corresponding to the unit pixel.
